(19) Europäisches Patentamt
European Patent Office
Office européen des brevets

(11) Publication number: 0 550 893 A1

# (12) EUROPEAN PATENT APPLICATION

(21) Application number: 92121970.5

(22) Date of filing: 24.12.92

(30) Priority: 10.01.92 IT MI920029
26.10.92 IT MI922441

(43) Date of publication of application:
14.07.93 Bulletin 93/28

(84) Designated Contracting States:
DE FR GB IT

(51) Int. Cl.5: G03F 7/022

(71) Applicant: MINNESOTA MINING AND MANUFACTURING COMPANY
3M Center, P.O. Box 33427
St. Paul, Minnesota 55133-3427(US)

(72) Inventor: Piro, Mario
3M Italia Ricerche S.p.A.
I-17016 Ferrania (Savona)(IT)

(74) Representative: Checcacci, Giorgio
PORTA, CHECCACCI & BOTTI s.r.l., Viale Sabotino, 19/2
I-20135 Milano (IT)

## (54) Light sensitive layer for positive-negative copying material.

(57) The present invention refers to a light-sensitive positive-acting layer which is also capable of working as negative imaging layer after a reversal process, comprising a 4- and/or 5-substituted diazo resin and a polymeric resin, wherein said layer further comprises a hindered phenol or polyphenol having a molecular weight higher than 108.

EP 0 550 893 A1

## FIELD OF THE INVENTION

The present invention refers to a light-sensitive positive-acting layer, capable of working also as a negative-acting layer, particularly useful for the preparation of offset printing plates.

## BACKGROUND OF THE ART

As known to those skilled in the art, light-sensitive positive layer based on orthoquinone diazides, mainly used in offset printing, if properly composed of particular ingredients, and subjected to a process of thermal reversal, becomes a light-sensitive layer working as a negative imaging system.

A positive image is obtained by exposing the light-sensitive layer through a positive film and then developing with an alkaline solution. The orthoquinone diazides under the action of light decompose in acid photodecomposition products which are washed off by the alkali solution.

It is known that a negative image can be obtained with a particular sequence of treatment steps. In US Patent No. 3,264,104, a reversal process of this kind is described in which the light-sensitive layer, which preferably comprises thermoplastic polymers, is imagewise exposed, treated with alkaline solution or with water (if appropriate at elevated temperature) without washing off the exposed area in the process, then exposed again without an original, and finally developed in a conventional manner, so that the originally imagewise exposed areas remain on the support and the other areas are washed off. This process has the disadvantages that a large number of treatment steps are required, that the first treatment with alkali must be carried out with particular care, to detach as little as possible of the exposed layer (which is soluble in aqueous alkali), and that it is necessary to add polymers which are sparingly soluble in alkali and which limit the applicability of the malerial to other uses.

US 4,576,901 discloses that a negative image can be obtained by heating, after imagewise exposure, a light sensitive layer comprising a orthoquinone diazide 4-sulfonic or carboxylic acid derivatives (usually referred to 214 diazo resins) and a novolak resin, then exposing again and finally developing with an alkaline solution. The novolak resin reacts with the products of the photoreaction undergone by the quinone diazide with heating of the material and produces an alkali insoluble compound. Said 214 diazo resins give a sufficient thermal reversal. On the contrary the thermal reversal of the 215 diazo resins (having the sulfonic or carboxylic group in the 5-position) is not possible.

As known in the art, various additives can promote the thermal reversal.

EP 24,916 discloses a similar reversal process for the production of light-sensitive layers, in which a photosensitive material based on orthoquinone diazides is heated after imagewise exposure, then exposed again without an original and developed with an aqueous alkaline solution to form a negative. The light-sensitive layer of the disclosed material comprises particular photochromic compounds which react with the products of the photoreaction undergone by the quinone diazide with heating of the material, and are stated to effect curing of the layer. In this material, photochromic compounds must be present, the photoreaction of which produces a discoloration which is inconvenient in some applications.

GB 2,082,339 describes a light-sensitive composition comprising o-quinone diazides and at least one resol, for use in the manufacturing of a lithographic printing plate which is suitable for both positive and negative processing. This reversal process covers the same sequence of steps as the process disclosed by the aforementioned EP 24,916. The reversal action is based on the fact that the photodecomposition products of the o-quinone diazide form an insoluble reaction product with the resol, under the action of heat. A reaction of this kind does not occur if novolaks are used. The printing plates so produced have the disadvantage of a relatively poor shelf-life, due to the self-curing character of resol.

DE 2,885,723 and US 4,104,070 describe light-sensitive layers comprising orthoquinone diazides, which layers are used for a reversal process and contain, in addition, N-acyl-N'-methylolethylenediamines or hydroxyethylimidazoles to effect thermal curing of the layer. A similar material comprising secondary or tertiary amines is described in US 4,196,003.

US 4,581,321 discloses a reversal process of orthoquinone diazide sulfonic or carboxylic acids by means of the addition of hexamethylol melamine ether.

Additive of this kind, however, generally have an adverse influence on the shelf-life of the copying layers and on specific properties relating to light and image contrast after exposure. Moreover, for many applications the temperature which is necessary to obtain an image reversal is too high, or the period of heating required at a lower temperature is too long.

Italian Patent Application 84932 A/90 discloses the use of a resin and/or a diazo resin derived from a phenol and/or a phenol derivative upon condensation with formaldehyde or from a vinylphenol and/or a vinylphenol derivative obtained upon free radical polymerization. This resin provides the best performance

in terms of thermal reversal when subjected to a purification process which reduces both free phenol and/or cresol and low molecular weight polymer fractions, providing a polymer with a reduced value of polidispersability.

With the material and the process described in the above mentioned Italian Patent Application, undeniable advantages can be obtained, such as, for example, absence of bad smells due to free phenol and/or cresol, toxicity reduction, wider latitude in the temperature range useful for reversal and in general a simpler manufacturing procedure.

Unfortunately, low storage stability and a reduction of developability, which occurs within a few months, have been observed.

The present invention provides a material having a wide reversal temperature latitude, very good baking ability and solvent resistance, and good storage stability and developability.

## SUMMARY OF THE INVENTION

The present invention refers to a light-sensitive positive-acting layer which is also capable of working as negative imaging layer after a reversal process, comprising a 4- and/or 5-substituted diazo resin and a polymeric resin, characterized in that said layer further comprises a hindered phenol or polyphenol having a molecular weight higher than 108.

In another aspect the present invention relates to a process for obtaining a negative image comprising the steps of:

(a) imagewise exposing to light, through an original, a light-sensitive material comprising a light-sensitive layer coated on a support, said light-sensitive layer comprising:
  (i) a 4- and/or 5-substituted diazo resin able to decompose under the action of the light,
  (ii) a polymeric resin,
  (iii) a hindered phenol or polyphenol having a molecular weight higher than 108,
(b) heating said light-sensitive material to render alkali-insoluble the exposed portion thereof,
(c) cooling said light-sensitive material,
(d) totally exposing said light-sensitive material to light, and
(e) developing said light-sensitive material with an alkaline developer.

In a further aspect the present invention relates to a process for obtaining a positive image comprising the steps of:

(a) imagewise exposing to light, through an original, a light-sensitive material comprising a light-sensitive layer coated on a support, said light-sensitive layer comprising:
  (i) a 4- and/or 5-substituted diazo resin able to decompose under the action of the light,
  (ii) a polymeric resin,
  (iii) a hindered phenol or polyphenol having a molecular weight higher than 108, and
(b) developing said light-sensitive material with an alkaline developer.

## DETAILED DESCRIPTION OF THE INVENTION

The diazo resins which can be used in the present invention are compounds which have at least one orthoquinonediazide group linked through the 4th or 5th position thereof to a cresol and/or phenol resin condensed with formaldehyde. The orthoquinonediazide group undergoes an increase in solubility in an alkaly solution upon irradiation with active light. The light promotes the photodecomposition of the orthoquinonediazide group, with emission of nitrogen and formation of photodecomposition acid products which are soluble in alkaline solutions.

The diazo resins derived from an orthoquinonediazide derivative are represented by the following formula:

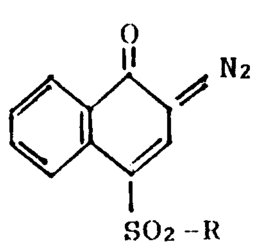

or

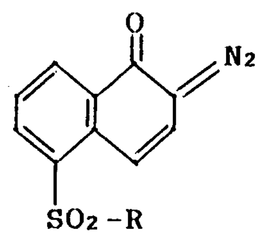

wherein R is a polymeric compound comprising acid hydrogens, such as, for example, polymers and copolymers of acrylic and methacrylic acids, polyamides, phenolformaldehyde resins, polyvinylphenols, polyvinylsulfonic acids, polyvinyl phosphonic acid, and the like. According to a preferred embodiment R is a phenol or cresol resin condensed with formaldehyde. The diazo resins are usually referred to 214 or 215 diazo resins, to indicate that the substitutions are in the 4$^{th}$or 5$^{th}$ position, respectively. Examples of such resins are known with the trade name RO 849 (214 diazo resin) and RO 223 (215 diazo resin), manufactured by Rohner (Switzerland).

The light-sensitive diazo resins are added to the light-sensitive layer of the present invention in an amount of from 20 to 80%, preferably of form 30 to 70% by weight of the total solid layer composition.

Examples of orthoquinone diazide derivatives can be found in J.Kosar, Light Sensitive Systems, Wiley & Sons, Inc. Sulfonic and carboxylic acid derivatives are preferred. Examples of 4- and 5-sulfonic acid derivatives can be found in US 3,046,118, 3,046,119, 3,046,121, 3,046,122, 3,046,123, and examples of 4- and 5-carboxylic acid derivatives can be found in US 4,581,321 and 4,576,901.

The light-sensitive layer composition can also include an orthoquinonediazide, as an alternative or in combination to the diazo resin.

According to a preferred embodiment of the present invention the orthoquinonediazides are represented by the following general formulas:

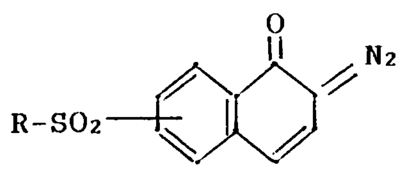

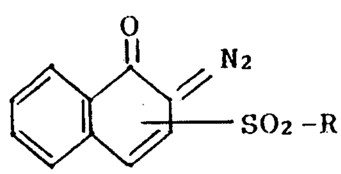

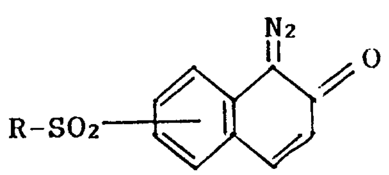

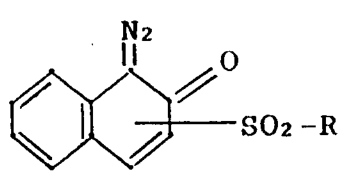

wherein R represents an aryl group. In the alternative, two orthoquinonediazide derivative groups can be linked by R.

Specific examples of orthoquinonediazides are:

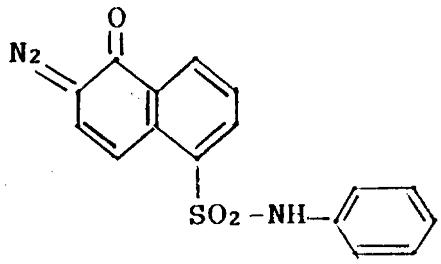

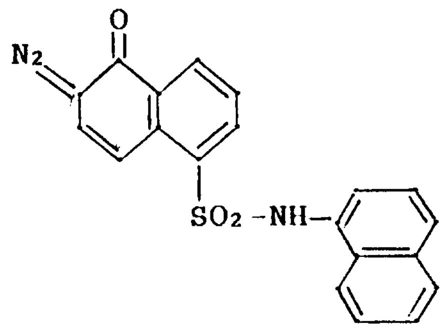

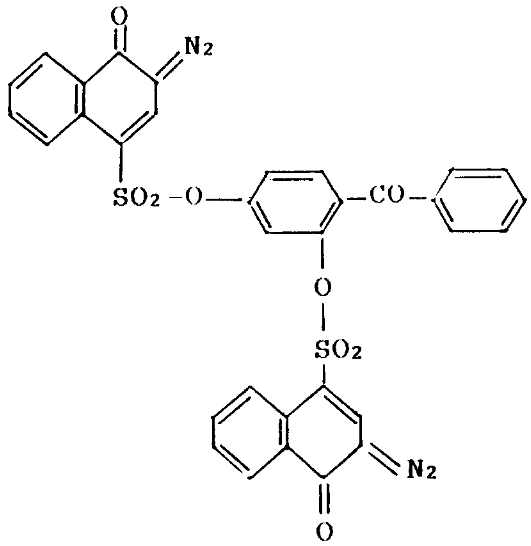

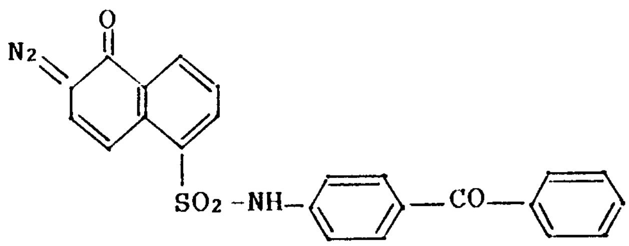

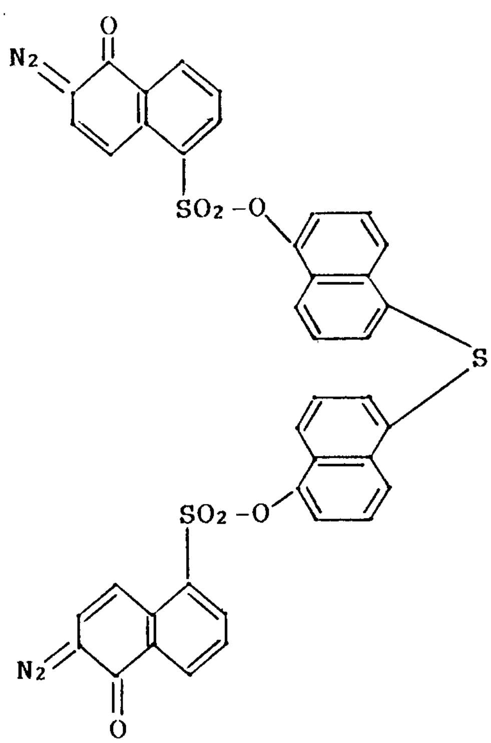

The hindered phenol or polyphenol compounds having a molecular weight higher than 108 of the present invention are aromatic compounds having one or more hydroxy group bonded to a benzene ring, said benzene ring being further substituted with alkyl groups, aryl groups, heterocyclic groups, and the like. By the term "hindered phenol" is meant a phenol derivative which is substituted on the $2^{nd}$ and/or $5^{rd}$position of the benzene ring (i.e., in ortho position relative to the hydroxy group), such substitution

creating a sterical hindering of the hydroxy group. Said hindered phenols and polyphenols are known in the art for their use as antioxidants. They are sold by various manufacturers under various trade names, such as, for example, Irganox™ (Ciba-Geigy Ltd.), Anti-oxidant™ (Bayer AG), Topanol™ and Nonox™ (Imperial Chemical Industries), Ionol™ (Shell Chemicals), Tenox™ (Eastman Chemical International AG), Santowhite™ (Monsanto), Age-Rite™ (Anchor Chemical Company) and the like. Each compound is identified by a number and/or a set of letters, such as, for example, Irganox™ 1010, Topanol™ OC, Age-Rite™ SPAR, and the like.

According to a preferred embodiment of the present invention said hindered phenol or polyphenol compounds may have the following general formulas.

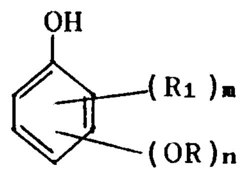

(I)

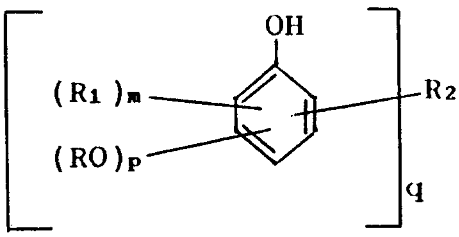

(II)

wherein R is H or an alkyl group, $R_1$ is an alkyl group or alkylene group, $R_2$ is a p-valent alkyl group, aryl group, aralkyl group or heterocycle group, m is an integer between 0 and 3, n is an integer between 1 and 4, p is an integer between 0 and 3, and q is an integer between 1 and 4.

The term "polyphenol compound" means both phenol compounds having more than one hydroxy group on a single benzene ring, and phenol compounds having more than one phenol groups linked by an organic group.

When the term "group" is used to describe a chemical compound or substituent, the described chemical material includes the basic group and that group with conventional substitution.

The group R is preferably represented by an alkyl chain having from 1 to 8 carbon atoms such as, for example, methyl, ethyl, propyl, isobutyl, octyl, and the like.

The group $R_1$ is preferably represented from an alkyl or alkylene chain having from 1 to 8 carbon atoms such as, for example, methyl, ethyl, propyl, propenyl, butyl, t-butyl, butenyl, pentyl, neopentyl, and the like.

The group $R_1$ is preferably represented by an aliphatic chain having at least 3 carbon atoms and the following general formula:

$-CH_2-CH_2-CO-X(R_3)_z$

wherein X represents O or N, $R_3$ represents an alkyl or cycloalkyl chain having from 1 to 20 carbon atoms and z is 1 or 2. Alternatively, $R_2$ can represent a substituted or unsubstituted aryl, or aromatic or non-aromatic nitrogen containing heterocycle group.

In particular the polyphenol compounds represented by the above general formula (II) include compounds known as Irganox™ manufactured by Ciba-Geigy Ltd. The phenol and polyphenol compounds are added to the light-sensitive layer of the present invention in an amount of from 0.1% to 50%, preferably of from 0.5% to 30%, more preferably of from 0.5% to 5% by weight of the total solid layer composition.

Specific examples of hindered phenol and polyphenol compounds according to the present invention are:

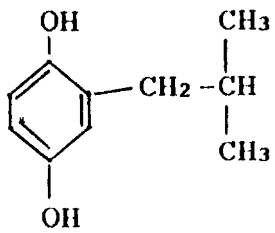

(1)

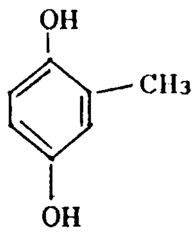

(2)

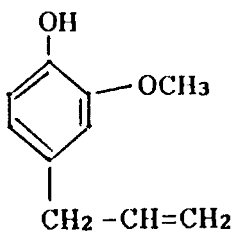

(3)

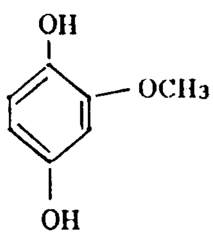

(4)

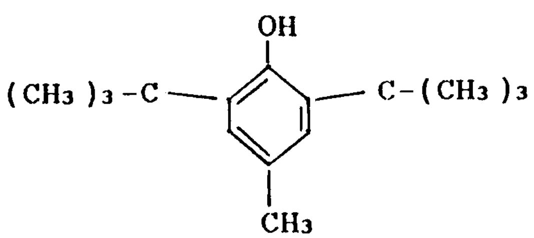

(5)

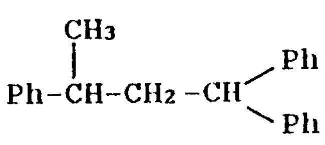

(6)

wherein Ph is:

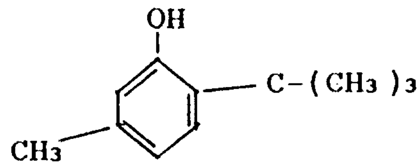

also known as Topanol CA™ manufactured by Imperial Chemical Industries,

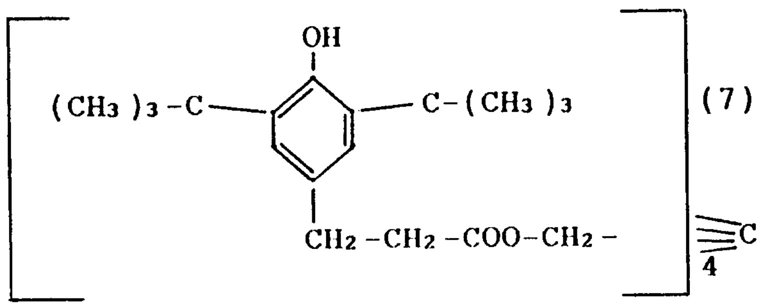

(7)

also known as Irganox 1010™

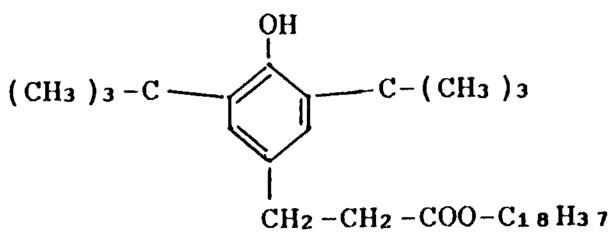

(8)

also known as Irganox 1076™

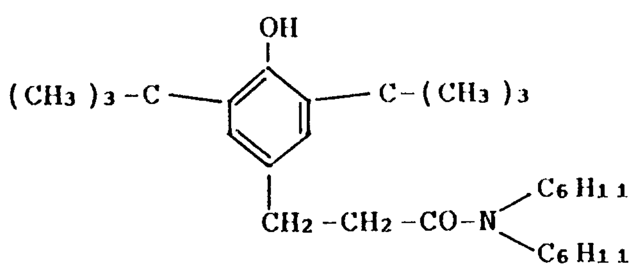

(9)

also known as Irganox 1098™

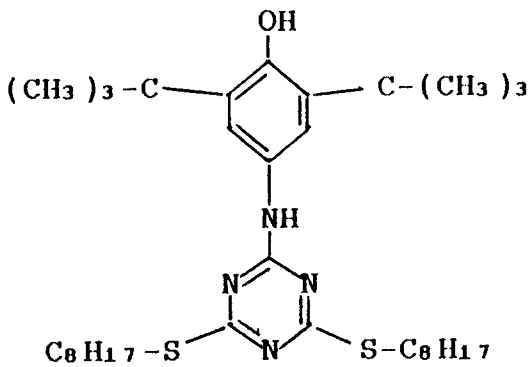

(10)

also known as Irganox 565™

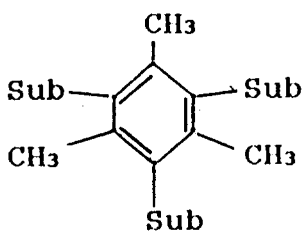

(11)

also known as Irganox 1330™

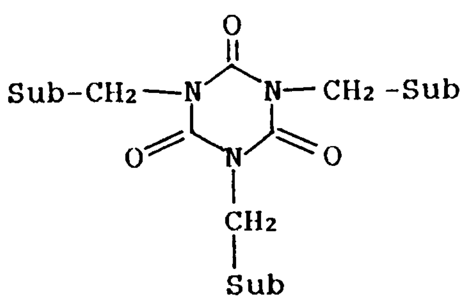

(12)

also known as Irganox 3114™
wherein Sub, in formulas 11 and 12, is:

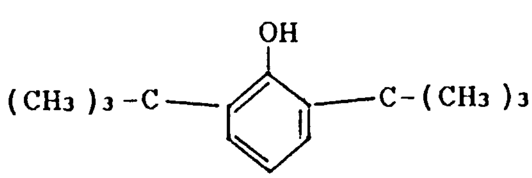

The light sensitive layer of the present invention further comprises a polymeric resin which is soluble in the solvents used for the layer composition, and is also soluble, or at least swellable, in aqueous alkaline solution. Example of polymeric resins useful in the layer of the present invention are, for example, novolak resins and derivatives thereof, resol resins and derivatives thereof, copolymers of maleic anhydride and styrene, polyacrylates, polymethacrylates, vinyl polymers and copolymers (such as polyvinylacetates, polyvinylethers, polyvinylpyrrolidones, polyvinylphenols), and the like.

According to a preferred embodiment of the present invention the alkali soluble polymeric resin is selected from the group consisting of phenol-formaldehyde resins and polyvinylphenol resins represented by the following general formulas:

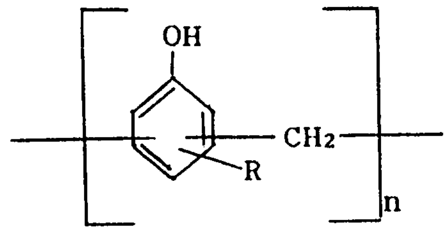

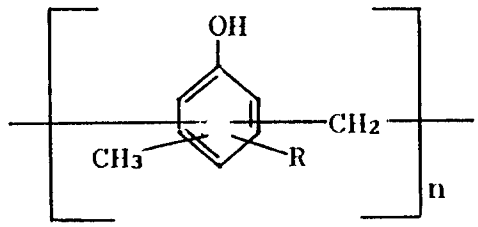

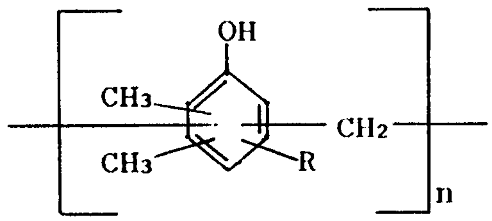

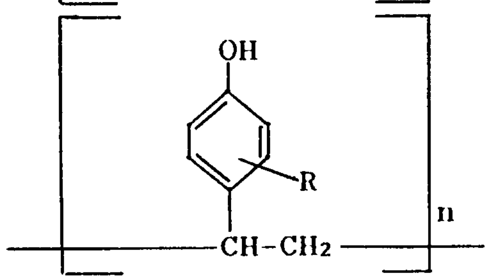

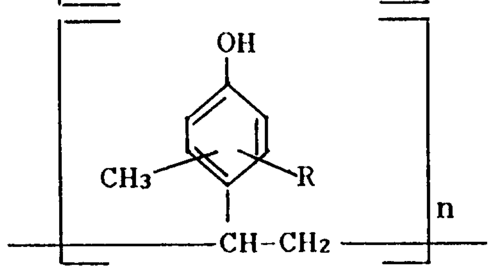

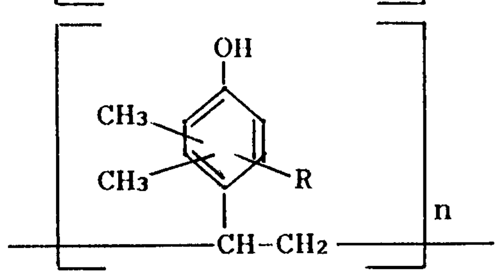

wherein R can be H, or an alkyl group (preferably of 1 to 12 carbon atoms) or aryl group (preferably of up to 20 carbon atoms, such as phenyl and naphthyl).

The alkali soluble polymeric resin is added to the light-sensitive layer composition of the present invention in an amount of from 20 to 80%, preferably of from 30 to 70% by weight of the total solid layer composition.

According to a preferred embodiment of the present invention both the polymers selected from the group consisting of phenol-formaldehyde resins and polyvinylphenol resins, and the diazo resins preferably have an average numeral molecular weight (Mn) between 900 and 2000, more preferably between 1100 and 1800, such as 1600, polydispersability (D = Mw/Mn wherein Mw is the average molecular weight) between 1.2 and 4, more preferably between 2 and 3, such as 2.8, and show, in 0.5% by weight acetone solution, a pH between 3 and 7, preferably between 4 and 5, such as 4.5.

Mn and Mw are obtained by the following formulas:

$$Mn = \frac{\Sigma\ Ni\ Mi}{\Sigma\ Ni} = \frac{W}{N}$$

$$Mw = \frac{\Sigma\ Ni\ Mi^2}{\Sigma\ Ni\ Mi} = \Sigma\ Wi\ Mi$$

wherein Ni represents the number of molecules having a molecular weight Mi, N represents the total number of molecules, Wi represents the weight fraction of molecules having a molecular weight Mi and W represents the total molecular weight.

The resin and diazoresin purification method, as described in the Italian Patent Application IT 84932 A/90, consists in dissolving the resin (or diazoresin) in commercial acetone, drop by drop dispersing the so obtained solution in tap-water, filtering the precipitate, and drying the filtrate in oven at 50°-60°C under a pressure of 1 mm Hg. After drying, the treatment is repeated to obtain the above mentioned values of average numeral molecular weight and polydispersability.

Advantageously, the composition of the photoresist or light-sensitive layer according the invention can include suitable additives improving rheologic and chemical-physical characteristics of the layer, such as DISPERBYK™ manufactured by BYK Chemie (Germany) and FLUORAD™ FC 129 manufactured by 3M Co. (USA).

According to a preferred embodiment, the composition can comprise other light-sensitive compounds, which form free or acid radicals under light exposure, such as halogenated triazine derivatives, as described in US Patent No. 3,987,037, US 3,954,475, US 4,239,850, US 4,189,323.

The photoresist composition can be added with dyes which impart a desired contrast after development, such as, for example, FLEXO 615 violet, FLEXO 640 blue and SUDAN 670 blue, all manufactured by BASF (Germany).

Dyes changing tone under light exposure and pH variations, can be advantageously used, besides the dyes above. The use of these dyes can distinguish an exposed area from unexposed areas. This is very useful, in particular for a reversal layer as above described, because one can immediately check where the first exposure took place (wherein the layer works as negative) and where the second exposure will take place (wherein the layer works as positive).

Such dyes can be, for example, bromophenol blue, bromocresol green, methyl orange and methyl red, all manufactured by 3M Co. (USA), ethylviolet, and the like.

As known in the art, a layer of light-sensitive composition is coated on a suitable support. Useful supports are: silicon plates, silicon plates coated with silicic anhydride, plates of aluminum or alloys thereof, chromium plates, nickel plates, stainless steel plates, brass plates, chromium-plated or copper-plated iron plates, rolled sections of epoxidic resin-glass, rolled sections of polyester resin-glass, glass plates, ceramic supports, thermoplastic material layers, and the like.

For example, in an offset printing matrix, the support can consist of mechanically and/or electrochemically grained aluminum, anodized with a known electrochemical technique. After that, the aluminum plate is coated with the light-sensitive composition above described.

Before the coating, the composition is generally dissolved in a suitable solvent. The choice of the solvent should consider the coating process to be used, the required layer thickness, the drying conditions, and the chemical inactivity relative to the components. Useful solvents are, for example, ketones, such as methyl ethyl ketone, alcohols, such as n-propanol, ethers, such as tetrahydrofuran, alcohol ethers, such as

ethylene glycol monoethyl ether, and esters, such as butyl acetate. Special purpose mixtures containing acetonitrile, dioxane, or dimethylformamide can also be used. According to a preferred embodiment of the present invention the preferred solvent is methyl ether ethylene glycol. The light-sensitive coating composition is prepared by dissolving the solid mixture of the proper components in the solvent at a weight ratio of from 10:90 to 30:70.

The coating of the support is performed according to any method known in the art such as, for example, by spin-coating, by spraying, by dipping, by roller-coating, by means of slot-dies, by blade-coating, and the like.

Any convenient light source or, alternatively, electron or laser sources, can be used for exposure. The aqueous alkaline solutions to be used for developing have a pH in the range of from 10 to 14 and can comprise minor amounts of solvents and surfactants.

After the imagewise exposure, the light-sensitive material is heated without any further intermediate treatment. The heating can be performed by irradiation, convection, contact with heated surface, such as heated rollers, or by immersion into a heated inert liquid. The temperature of the heating ranges from 100°C to 200°C, preferably from 125°C to 170°C. The components of the light-sensitive layer of the present invention are not altered in the unexposed areas. The components of the exposed areas change their chemical properties and became alkali-insoluble. The heating time ranges from 10 seconds to 10 minutes, preferably from 30 seconds to 5 minutes, more preferably from 40 seconds to 2 minutes. The thermal reversal promotes the formation of alkali insoluble compounds in the exposed areas.

After heating and cooling, the light-sensitive layer of the present invention is subjected to a second exposure over its total surface. During this second exposure the previously unexposed areas (which are still sensible to light) change their chemical composition into their photodecomposition products (which are alkali-soluble).

Following the second exposure the light-sensitive layer of the present invention is developed by means of conventional alkaline developers. The areas not exposed during the first imagewise exposure are washed off.

Examples of developers which can be used in the processing of the light-sensitive layer of the present invention are, for example, aqueous alkaline solutions comprising alkali-metal phosphates, silicates, carbonates, or hydroxydes, and additionally small amounts of surfactants and/or organic solvents.

The advantages of the present invention reside in a very broad range of reversal temperatures, short reversal times, very sharp negative images, very good solvent resistance, baking ability, good storage stability and developability.

The invention will be further described in greater detail in the following examples. The invention is not intended to be limited thereto. All percentages are expressed by weight of total solid composition, unless otherwise mentioned.

STANDARD PROCESSING

The light-sensitive composition was prepared by dissolving the solid mixture described in the following examples in a solvent, consisting of a mixture 8:1 by weight of methylether ethyleneglycol and ethylene glycol, and stirring over night at room temperature. An electrochemically oxidized aluminum plate, properly pretreated and dried was used as a coating support. The coating was performed by a conventional coating machine manufactured by R&K Coat Instrument LTD (UK). After drying the coated plate at 100°C for 5 minutes and then at 120°C for 1 minute, the measured coverage was of about 2.0 g/m$^2$. The exposures were realized by a Sack LCX instrument having 5 KWatt lamps at an energy intensity of 118 mJ/cm$^2$. The reversal of the positive image was performed in a air oven at 135°C for 60 seconds. Development was made with an alkaline developer LL/T manufactured by Diaprint 3M Italia for a total development time of 30 seconds at 22°C.

The exposure latitude, resolution, gradation and dot definition results are obtained by the UGRA-Plate Control Wedge of the Association for the Promotion of Research in the Graphic Art Industry. The number of "clean" steps of UGRA-Plate represents the step number which, for a positive material, are white (i.e., not printed) and is an index of gradation and correct exposure of the plate. For a negative material the same index is expressed in terms of "solid" steps which are black (i.e., printed). The resolution is represented by the width of the thinner micro-lines of the UGRA-Plate Control Wedge (in $\mu$m) reproduced on the plate in a visible manner. The dot definition is represented by the dot percentage of the UGRA-Plate Control wedge reproduced on the plate. Of course, the resolution and dot definition values are related with the correct exposure of the plate.

EXAMPLE 1

A solid mixture having the following formulation was prepared:

35.0% of a purified p-cresol novolak resin having a high average molecular weight and a low content of mono-, di-, and tri-cresols,

50.5% of a 215 diazo resin, obtained from the reaction of a p-cresol novolak resin and 5-sulfonylchloride-o-quinonediazide,

12.0% of a m-cresol novolak resin HJR 11119 manufactured by Schenectady Co., USA,

0.44% of a halogenated triazine derivative,

1.40% of ethylviolet dye, and

0.64% of Maxillon blue dye.

After the procedure described in the standard conditions, no image was found on the plate. All of the coating was washed off.

EXAMPLE 2

A solid mixture having the following formulation was prepared:

35.0% of a purified p-cresol novolak resin having a high average molecular weight and a low content of mono-, di-, and tri-cresols,

50.5% of a 215 diazo resin, obtained from the reaction of a p-cresol novolak resin and 5-sulfonylchloride-o-quinonediazide,

9.0% of a m-cresol novolak resin HJR 11119 manufactured by Schenectady Co., USA,

3.0% of Irganox™ 1010, manufactured by Ciba-Geigy Ltd.,

0.44% of a halogenated triazine derivative,

1.40% of ethylviolet dye, and

0.64% of Maxillon blue dye.

After the above described standard processing the plate shows a strong negative image, showing 2 UGRA solid steps and 6 UGRA micro-lines.

EXAMPLE 3

A solid mixture having the following formulation was prepared:

35.0% of a purified p-cresol novolak resin having a high average molecular weight and a low content of mono-, di-, and tri-cresols,

50.5% of a 215 diazo resin, obtained from the reaction of a p-cresol novolak resin and 5-sulforiylchloride-o-quinonediazide,

12.0% of Irganox™ 1010, manufactured by Ciba-Geigy Ltd.,

0.44% of a halogenated triazine derivative,

1.40% of ethylviolet dye, and

0.64% of Maxillon blue dye.

After the above described standard processing the plate shows a good negative image, showing 3 UGRA solid steps and 8 UGRA micro-lines.

EXAMPLE 4

A solid mixture having the following formulation was prepared:

35.0% of a p-cresol novolak resin LB 744 manufactured by Bakelite AG, Germany,

45.5% of a 215 diazo resin, obtained from the reaction of a p-cresol novolak resin and 5-sulfonylchloride-o-quinonediazide,

2.0% of a 215 bis-diazoester manufactured by Ward Blenkinsop Ltd., U.K.,

15.0% of Irganox™ 1010, manufactured by Ciba-Geigy Ltd.,

0.44% of a halogenated triazine derivative,

1.40% of ethylviolet dye, and

0.64% of Maxillon blue dye.

After the above described standard processing the plate shows a good negative image, showing 3 UGRA solid steps and 8 UGRA micro-lines.

EXAMPLE 5

A solid mixture having the following formulation was prepared:

50.0% of a 214 diazo resin RO 849, manufactured by Rohner Co., Switzerland,

47.5% of a m-cresol novolak resin L-6484 manufactured by Schenectady Co., USA,

0.44% of a halogenated triazine derivative,

1.40% of ethylviolet dye, and

0.64% of Maxillon blue dye.

After the above described standard processing, no image was found on the plate. All the coating was washed off.

EXAMPLE 6

A solid mixture having the following formulation was prepared:

12.0% of a 214 diazo resin RO 849, manufactured by Rohner Co., Switzerland,

35.0% of a m-cresol novolak resin L-6484 manufactured by Schenectady Co., USA,

25.0% of a 214 diazo resin, obtained from the reaction of a p-cresol novolak resin and 4-sulfonylchloride-o-quinonediazide,

25.5% of a m-cresol novolak resin HJR 11119 manufactured by Schenectady Co., USA,

0.44% of a halogenated triazine derivative,

1.40% of ethylviolet dye, and

0.64% of Maxillon blue dye.

After the above described standard processing the plate shows a poor negative image.

EXAMPLE 7

A solid mixture having the following formulation was prepared:

57.5% of a 214 diazo resin RO 849, manufactured by Rohner Co., Switzerland,

7.0% of a 214 diazo resin, obtained from the reaction of a p-cresol novolak resin and 4-sulfonylchloride-o-quinonediazide,

30.0% of a m-cresol novolak resin HJR 11119 manufactured by Schenectady Co., USA,

3.0% of Irganox™ 1098, manufactured by Ciba-Geigy Ltd.,

0.44% of a halogenated triazine derivative,

1.40% of ethylviolet dye, and

0.64% of Maxillon blue dye.

After the above described standard processing the plate shows a strong negative image, showing 2 UGRA solid steps and 6 UGRA micro-lines.

EXAMPLE 8

A solid mixture having the following formulation was prepared:

48.7% of a 214 diazo resin, obtained from the reaction of a p-cresol novolak resin and 4-sulfonylchloride-o-quinonediazide,

48.8% of a m-cresol novolak resin HJR 11119 manufactured by Schenectady Co., USA,

0.44% of a halogenated triazine derivative,

1.40% of ethylviolet dye, and

0.64% of Maxillon blue dye.

After the above described standard processing the plate shows a poor negative image.

EXAMPLE 9

A solid mixture having the following formulation was prepared:

48.2% of a 214 diazo resin, obtained from the reaction of a p-cresol novolak resin and 4-sulfonylchloride-o-quinonediazide,

37.4% of a m-cresol novolak resin HJR 11119 manufactured by Schenectady Co., USA,

11.9% of Irganox™ 1330, manufactured by Ciba-Geigy Ltd.,

0.44% of a halogenated triazine derivative,

1.40% of ethylviolet dye, and

0.64% of Maxillon blue dye.

After the above described standard processing the plate shows a good negative image, showing 2 UGRA solid steps and 6 UGRA micro-lines.

EXAMPLE 10

A solid mixture having the following formulation was prepared:

48.2% of a 214 diazo resin, obtained from the reaction of a p-cresol novolak resin and 4-sulfonylchloride-o-quinonediazide,

37.4% of a m-cresol novolak resin HJR 11119 manufactured by Schenectady Co., USA,

11.9% of Irganox™ 1076, manufactured by Ciba-Geigy Ltd.,

0.44% of a halogenated triazine derivative,

1.40% of ethylviolet dye, and

0.64% of Maxillon blue dye.

After the above described standard processing the plate shows a good negative image, showing 1 UGRA solid steps and 6 UGRA micro-lines.

EXAMPLE 11

A solid mixture having the following formulation was prepared:

48.2% of a 214 diazo resin, obtained from the reaction of a p-cresol novolak resin and 4-sulfonylchloride-o-quinonediazide,

37.4% of a m-cresol novolak resin HJR 11119 manufactured by Schenectady Co., USA,

11.9% of Irganox™ 3114, manufactured by Ciba-Geigy Ltd.,

0.44% of a halogenated triazine derivative,

1.40% of ethylviolet dye, and

0.64% of Maxillon blue dye.

After the above described standard processing the plate shows a good negative image, showing 2 UGRA solid steps and 8 UGRA micro-lines.

EXAMPLE 12

A solid mixture having the following formulation was prepared:

60% of a purified m-cresol novolak resin having a average numeral molecular weight (Mn) of about 1600, a polydispersability value (D) of about 2.8 and a content of mono-, di-, and tri-cresols lower than 0.2%,

10% of a 214 diazo resin RO 849, manufactured by Rohner Co., Switzerland,

24% of a 215 diazoresin, obtained from the reaction of a p-cresol novolak resin and of 5-sulfonylchloride-o-quinonediazide,

4% of a halogenated triazine derivative,

2% of dyes, in particular about 1.4% of ethylviolet and about 0.6% of Maxillon blue.

After the procedure described in the standard condition the plate was exposed as positive and developed, showing the following results:

| | |
|---|---|
| UGRA grey step | 4 clean<br>5 ghost |
| UGRA Micro-lines<br>Dots | 15<br>2% |

After storage for two months at room temperature, the same kind of plate exposed as positive and developed showed the following results:

| | |
|---|---|
| UGRA grey step | 2 clean<br>3 ghost |
| UGRA Micro-lines<br>Dots | 8-10<br>1-2% |

After storage for two months at room temperature, the same kind of plate added with 0.5% by of Irganox™ 1010 exposed as positive and developed showed the following results:

| | |
|---|---|
| UGRA grey step | 4 clean<br>5 ghost |
| UGRA Micro-lines<br>Dots | 15<br>2% |

No change of the results has been observed also on plates stored for 6 or 12 months at room temperature before exposure. The use of a mixture of Irganox™ 1010 (0,25%) and Irganox™ 1076 (0,25%) or of Irganox™ 1010 (0,25%) and BHT (0,25%) has led to the same results after two months storage at room temperature. The term BHT represents in the art the 2,6-di-t-butyl-4-hydroxytoluene.

EXAMPLE 13

A solid mixture having the following formulation was prepared:

60% of a purified m-cresol novolak resin having a average numeral molecular weight (Mn) of about 1600, a polydispersability value (D) of about 2.8 and a content of mono-, -di-, and tri-cresols lower than 0.2%,

10% of a 214 diazo resin RO 849, manufactured by Rohner Co., Switzerland,

24% of a 214 diazoresin, obtained from the reaction of a p-cresol novolak resin and of 4-sulfonylchloride-o-quinonediazide,

4% of a halogenated triazine derivative,

2% of dyes, in particular about 1.4 of ethylviolet and about 0.6% of Maxillon blue.

After the procedure described in the standard condition the plate was exposed as positive and developed, showing the following results:

| | |
|---|---|
| UGRA grey step | 4 clean<br>5 ghost |
| UGRA Micro-lines<br>Dots | 12-15<br>2% |

After storage for two months at room temperature, the same kind of plate exposed as positive and developed showed the following results:

| | |
|---|---|
| UGRA grey step<br>UGRA Micro-lines<br>Dots | 2 clean<br>8<br>1% |

After storage for two months at room temperature, the same kind of plate added with 0.5% of Irganox™ 1010 exposed as positive and developed showed the same results as the fresh plate. No change of results was observed on plates stored for 6 or 12 months at room temperature before exposure.

## Claims

**1.** A light-sensitive positive-acting layer which is also capable of working as a negative imaging layer after a reversal process, comprising a 4- and/or 5-substituted diazo resin and a polymeric resin, characterized in that said layer further comprises a hindered phenol or polyphenol having a molecular weight

higher than 108.

**2.** The layer according to claim 1 characterized in that said hindered phenol or polyphenol is represented by the formula:

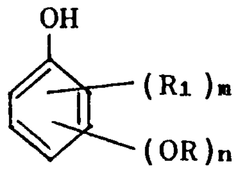

(I)

wherein R is H or an alkyl group, $R_1$ is an alkyl group or alkylene group, m is an integer between 0 and 3, and n is an integer between 1 and 4.

**3.** The layer according to claim 1 characterized in that said hindered phenol or polyphenol is represented by the formula:

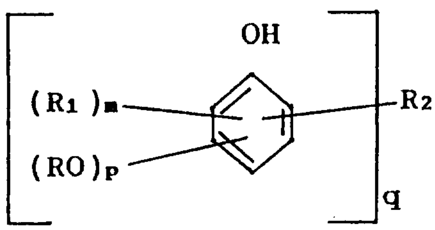

(II)

wherein R is H or an alkyl group, $R_1$ is an alkyl group or alkylene group, $R_2$ is a p-valent alkyl, aryl, aralkyl or heterocycle group, m is an integer between 0 and 3, p is an integer between 0 and 3, and q is an integer between 1 and 4.

**4.** The layer according to claim 1 characterized in that said hindered phenol or polyphenol amounts from 0.1 to 50% by weight of the total solid layer composition.

**5.** The layer according to claim 1 characterized in that said diazo resin has the formulas:

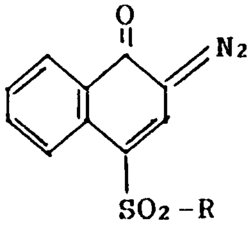

or

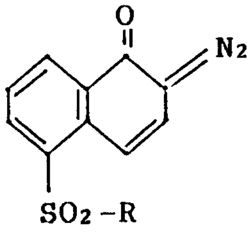

wherein R is a polymeric compound comprising acid hydrogens.

**6.** The layer according to claim 5 characterized in that R is a phenol or cresol resin condensed with formaldehyde

**7.** The layer according to claim 5 characterized in that said diazo resin shows an average numeral molecular weight Mn between 900 and 2000 and a polydispersability D = Mw/Mn between 1.2 and 4.

**8.** The layer according to claim 1 characterized in that it comprises, in alternative or in combination to said diazo resin, a light-sensitive orthoquinonediazide derivative having the formulas:

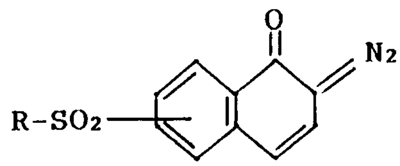

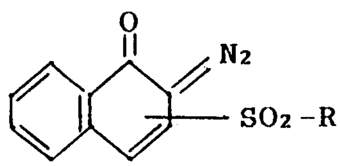

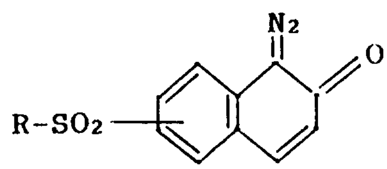

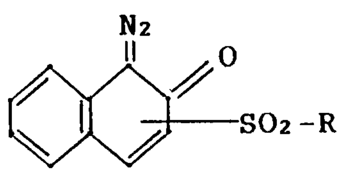

wherein R represents an aryl group.

**9.** The layer according to claim 1, characterized in that said polymeric resin is selected in the group consisting of novolak resins and derivatives thereof, resol resins and derivatives thereof, copolymers of maleic anhydride and styrene, polyacrylates, polymethacrylates, vinyl polymers and copolymers.

**10.** The layer according to claim 1, characterized in that said polymeric resin is selected from the group consisting of phenol-formaldehyde resins and polyvinylphenol resins represented by the following general formulas:

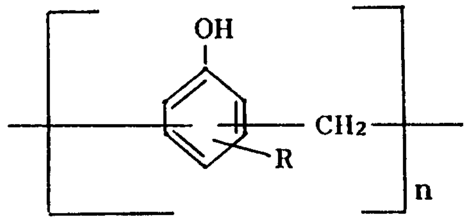

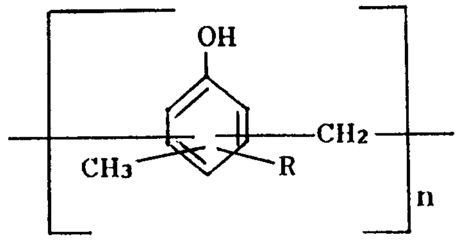

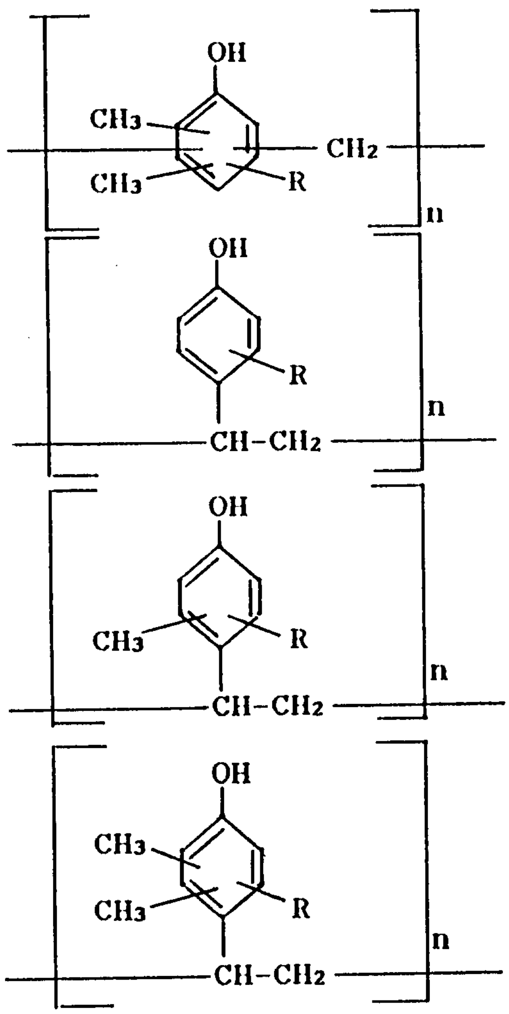

wherein R can be H, or an alkyl group of from 1 to 12 carbon atoms or an aryl group of up to 20 carbon atoms.

**11.** The layer according to claim 10 characterized in that said polymeric resin selected from the group consisting of phenol-formaldehyde resins and polyvinylphenol resins, shows an average numeral molecular weight Mn between 900 and 2000 and a polydispersability D = Mw/Mn between 1.2 and 4.

**12.** The layer according to any preceding claims characterized in that it comprises at least one additive to improve the rheological and chemical-physical characteristics of the layer.

**13.** The layer according to any preceding claims characterized in that it comprises halogenated triazine derivatives which form free or acid radical under light exposure.

**14.** The layer according to any preceding claims characterized in that it comprises at least one dye which impart a desired contrast after development.

**15.** The layer according to any preceding claims characterized in that it comprises at least one dye, which changes tone under light exposure and pH variations, able to distinguish exposed areas from non-exposed areas.

**16.** A process for obtaining a negative image comprising the steps of:
(a) imagewise exposing to light, through an original, a light-sensitive material comprising a light-sensitive layer coated on a support, said light-sensitive layer comprising:
(i) a 4- and/or 5-substituted diazo resin able to decompose under the action of the light,
(ii) a polymeric resin,
(iii) a hindered phenol or polyphenol having a molecular weight higher than 108,
(b) heating said light-sensitive material to render alkali-insoluble the exposed portion thereof,
(c) cooling said light-sensitive material,
(d) totally exposing said light-sensitive material to light, and
(e) developing said light-sensitive material with an alkaline developer.

**17.** A process for obtaining a positive image comprising the steps of:
(a) imagewise exposing to light, through an original, a light-sensitive material comprising a light-sensitive layer coated on a support, said light-sensitive layer comprising:
(i) a 4- and/or 5-substituted diazo resin able to decompose under the action of the light,
(ii) a polymeric resin,
(iii) a hindered phenol or polyphenol having a molecular weight higher than 108, and
(b) developing said light-sensitive material with an alkaline developer.

European Patent Office

# EUROPEAN SEARCH REPORT

Application Number

EP 92 12 1970

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 461 654 (SUMITOMO CHEMICAL COMP.)<br>* page 3, line 1 - line 13; claim 2 *<br>--- | 1-17 | G03F7/022 |
| X | PATENT ABSTRACTS OF JAPAN<br>vol. 14, no. 162 (P-1029)29 March 1990<br>& JP-A-20 18 562 ( KONICA CORP. )<br>* abstract *<br>--- | 1-17 | |
| X | EP-A-0 445 819 (FUJI PHOTO FILM CO LTD)<br>* page 14, line 20 - line 35 *<br>--- | 1-17 | |
| A | EP-A-0 358 871 (SUMITOMO CHEMICAL COMP.)<br>----- | 1-17 | |

TECHNICAL FIELDS SEARCHED (Int. Cl.5 )

G03F

The present search report has been drawn up for all claims

| Place of search | Date of completion of the search | Examiner |
|---|---|---|
| THE HAGUE | 23 MARCH 1993 | HAENISCH U.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document